(19) Europäisches Patentamt
European Patent Office
Office européen des brevets

(11) EP 0 968 154 B1

(12) **FASCICULE DE BREVET EUROPEEN**

(45) Date de publication et mention de la délivrance du brevet:
**15.10.2003 Bulletin 2003/42**

(21) Numéro de dépôt: **98914915.8**

(22) Date de dépôt: **13.03.1998**

(51) Int Cl.[7]: **C04B 41/87**, C04B 35/83

(86) Numéro de dépôt international:
**PCT/FR98/00515**

(87) Numéro de publication internationale:
**WO 98/040327 (17.09.1998 Gazette 1998/37)**

(54) **PROCEDE DE DENSIFICATION D'UNE STRUCTURE POREUSE FAISANT INTERVENIR UN PRECURSEUR AROMATIQUE**

VERFAHREN ZUR VERDICHTUNG EINER PORÖSEN STRUKTUR UNTER ANWENDUNG EINES AROMATISCHEN VORPRODUKTES

METHOD FOR DENSIFYING A POROUS STRUCTURE USING AN AROMATIC PRECURSOR

(84) Etats contractants désignés:
**DE FR GB IT SE**

(30) Priorité: **13.03.1997 FR 9702986**

(43) Date de publication de la demande:
**05.01.2000 Bulletin 2000/01**

(73) Titulaire: **SOCIETE NATIONALE D'ETUDE ET DE CONSTRUCTION DE MOTEURS D'AVIATION, "S.N.E.C.M.A."**
**75015 Paris (FR)**

(72) Inventeurs:
- **DAVID, Patrick**
  **F-75014 Paris (FR)**
- **BENAZET, Jean-Daniel**
  **F-37260 Artannes (FR)**

(74) Mandataire: **Le Roux, Martine et al**
**Cabinet Beau de Loménie**
**158, rue de l'Université**
**75340 Paris Cédex 07 (FR)**

(56) Documents cités:
**EP-A- 0 081 409** **WO-A-90/15776**
**US-A- 5 547 717**

- **YOSHIKAZU NAKAMURA ET AL: "IR ABSORPTION AND RAMAN SPECTRA OF AS-DEPOSITED AND ANNEALED HYDROGENATED AMORPHOUS CARBON FILMS BY PLASMA DECOMPOSITION OF TOLUENE" JOURNAL OF THE AMERICAN CERAMIC SOCIETY, vol. 74, no. 11, 1 novembre 1991, pages 2932-2933, XP000243579**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).



Printed by Jouve, 75001 PARIS (FR)

## Description

La présente invention a pour objet un procédé de densification d'une structure poreuse faisant intervenir un précurseur original.

La présente invention constitue un perfectionnement à la technique de base dite de "densification par caléfaction ou densification rapide" selon laquelle les structures poreuses à densifier sont maintenues immergées dans un hydrocarbure liquide et l'ensemble structure poreuse/hydrocarbure liquide est chauffé (le chauffage mis en oeuvre est généralement un chauffage inductif et/ou résistif). Ladite technique de base, décrite, notamment dans la demande FR-A-2 516 914 (déposée le 26 novembre 1981) permet d'obtenir des densifications, notamment par du carbone, en un temps beaucoup plus court qu'avec les procédés classiques, tels :

- l'infiltration chimique en phase vapeur (dite CVI) (procédé selon lequel on place la structure à densifier dans un courant gazeux et on porte l'ensemble à une température élevée de sorte que le carbone obtenu par décomposition dudit gaz (précurseur) se dépose en partie dans les vides de la structure. Les gaz les plus souvent employés sont le méthane, le propane, le benzène et des hydrocarbures à bas poids moléculaire. Les procédés industriels emploient principalement le méthane);
  ou
- l'imprégnation par des brais (procédé selon lequel on plonge la structure à densifier dans un bain liquide de brai et on pyrolyse ensuite en statique ledit brai).

Des modifications ont été proposées, pour optimiser ladite technique de base, dans les brevets US-A-5,389,152 et US-A-5,547,717. Lesdites modifications sont des modifications d'ordre technologique ou des modifications de paramètres de procédé qui ne découlent nullement d'une optimisation au niveau de la nature du précurseur de carbone intervenant : l'hydrocarbure liquide (dans lequel les structures à densifier sont maintenues immergées).

Le précurseur de référence de ladite technique de base, modifiée ou non, reste le cyclohexane (voir FR-A-2 516 914 et les exemples desdits brevets US-A-5,389.152 et US-A-5,547,717). L'intervention d'autres précurseurs a certes été mentionnée :

- celle du n-hexane et du benzène dans ledit brevet US-A-5,389,152 ; et
- celle du cyclopentane, du cyclohexène, de l'hex-1-ène, de l'essence, du toluène, du méthylcyclohexane, du n-hexane, du benzène ou d'un de leurs mélanges dans ledit brevet US-A-5,547,717 ; mais, comme indiqué ci-dessus, cette intervention d'autres précurseurs n'a jamais résulté d'une réelle optimisation, n'a jamais été décrite comme conduisant à des résultats inattendus.

Il a maintenant été découvert, dans le cadre de la présente invention, que la mise en oeuvre de cette technique (densification par caléfaction d'une structure poreuse, modifiée ou non) avec certains composés aromatiques permet d'augmenter, de façon significative, les vitesses de dépôt du carbone ainsi que les rendements en carbone

$$(\text{rendement en carbone (\%)} = 100 \times \frac{M_{\text{carbone déposé}}}{M_{\text{totale de carbone de précurseur employé}}}),$$

obtenus avec le précurseur de référence de l'art antérieur : le cyclohexane, ainsi qu'avec d'autres précurseurs du type alcane linéaire ou alcane cyclique ou alcène.

Le cyclohexane permet d'obtenir, de façon classique, pour des températures de 1100°C, des vitesses de densification (ou de dépôt) de 1 à 2 mm/h et des rendements en carbone de 10 à 20 %. Cela représente déjà, par rapport aux procédés classiques de CVI, un gain d'un facteur 10 à 100 sur les vitesses de dépôt et un gain d'un facteur 2 à 4 sur le rendement.

La Demanderesse a obtenu avec d'autres précurseurs du type indiqué ci-dessus (alcanes linéaires (hexane, pentane), cycloalcanes (méthylcyclohexane), alcènes) des résultats similaires à, voire moins bons que, ceux obtenus avec le cyclohexane.

De manière surprenante, avec des composés aromatiques, elle a obtenu des résultats nettement meilleurs que ceux obtenus avec ledit cyclohexane. Elle a notamment obtenu, à 1 100°C, avec lesdits précurseurs originaux, des vitesses de dépôt et des rendements en carbone qui peuvent dépasser, respectivement, les 5 mm/h et les 90 %. Par ailleurs, d'autres avantages, totalement inattendus, ont été mis en évidence avec l'emploi des précurseurs originaux de l'invention, et notamment :

- une quantité de gaz de réaction générés bien plus faible que celle générée lorsque le cyclohexane intervient;

- une quantité d'énergie (d'électricité) consommée bien plus faible que celle consommée lorsque le cyclohexane intervient.

L'intervention desdits composés aromatiques, à titre de précurseurs originaux de carbone, dans la mise en oeuvre de la densification par caléfaction d'une structure poreuse constitue l'objet de la présente invention.
Plus précisément, ledit objet consiste en un procédé de densification d'une structure poreuse selon lequel :

- de façon classique, on maintient ladite structure poreuse immergée dans un hydrocarbure liquide et l'on chauffe l'ensemble : structure poreuse/hydrocarbure liquide, de sorte que le carbone obtenu par décomposition dudit hydrocarbure liquide se dépose en partie dans les pores de ladite structure poreuse (procédé par caléfaction classique);
  et
- de façon originale : + ledit hydrocarbure liquide est un composé aromatique qui répond à l'une ou à l'autre des formules (I) et (II) ci-après:

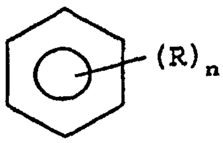 (I) 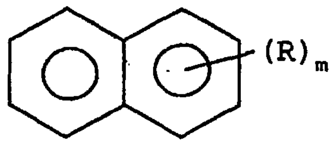 (II)

dans lesquelles :

n = 1,2, 3 ou 4,
m = 0,1,2,3 ou 4,
R représente, indépendamment, un halogène, de préférence le chlore, ou un groupement alkyle choisi parmi les groupes méthyle, éthyle, n-propyle ou i-propyle,

ou consiste en un mélange d'au moins deux composés aromatiques répondant à l'une et/ou l'autre desdites formules (I) et (II) ; et
+ on pilote ledit procédé en fonction du débit et de la composition des gaz de la réaction.
Le précurseur de carbone dont l'intervention est préconisée dans le cadre de la présente invention, consiste donc:

- en un dérivé du benzène,
- en le naphtalène,
- en un dérivé du naphtalène,
- ou en un mélange de ces composés.

Lesdits dérivés du benzène et du naphtalène comportent de 1 à 4 substituants, identiques ou différents, choisis, indépendamment, parmi les halogènes et les alkyles inférieurs. Les dérivés du naphtalène présentent indifféremment leurs substituants sur l'un et/ou l'autre des deux noyaux.
L'intervention du chlore, à titre de substituant halogéné (X) est particulièrement préférée mais celle, conjointe ou indépendante de celle dudit chlore, des autres halogènes (X=F, Br, I, At) fait partie intégrante du cadre de la présente invention. La présence d'au moins un substituant halogéné (X) dans la structure du précurseur de carbone selon l'invention est avantageuse dans la mesure où la liaison $C_{ar}$-X (Carbone aromatique - Halogène) est une liaison plus faible que les liaisons $C_{ar}$-$C_{alk}$ (Carbone aromatique - Carbone aliphatique) ou $C_{ar}$-H (Carbone aromatique - Hydrogène).
L'intervention des substituants alkylés qui peut se révéler opportune pour diverses raisons et notamment en référence la toxicité des composés a été limitée à celle des alkyles inférieurs, en référence au paramètre rendement en carbone.
On rappelle ici, qu'avec les composés aromatiques identifiés ci-dessus, utilisés à titre d'hydrocarbure liquide, précurseur de carbone dans un procédé de caléfaction, la Demanderesse a obtenu des résultats inattendus, particulièrement avantageux en termes de vitesse de dépôt de carbone, de rendement en carbone, d'énergie consommée...
Comme indiqué ci-dessus, la réaction de caléfaction est mise en oeuvre avec la structure poreuse à densifier immergée dans le précurseur liquide appelé à se décomposer dans la mesure où il est chauffé, généralement par induction et/ou effet Joule, à des températures adéquates. Les précurseurs de l'invention, identifiés ci-dessus, étant

des composés, liquides ou solides à la température ambiante, il convient de prévoir, dans le cadre de la présente invention, des moyens pour assurer la fusion desdits composés solides. Ainsi, prévoit-on avantageusement la fusion desdits composés solides (exemple, le 2-méthylnaphtalène) en amont du réacteur de caléfaction (au sein duquel le procédé de l'invention est mis en oeuvre) ainsi que l'alimentation, par des moyens adéquats, dudit réacteur en lesdits composés maintenus à l'état liquide.

Dans le cadre du procédé de caléfaction de l'invention, on préconise tout particulièrement l'intervention, à titre d'hydmcarbure liquide précurseur de carbone, du chlorobenzène ou du toluène.

Le procédé de l'invention est piloté en fonction du débit et de la composition des gaz de la réaction. En effet, la Demanderesse a constaté que la température de la réaction de densification est avantageusement pilotée en fonction du débit et de la composition des gaz de la réaction; i.e. qu'elle préconise la régulation de la puissance du générateur par le débit et la composition desdits gaz. Elle a, dans ces conditions, obtenu des résultats meilleurs par rapport à ceux obtenus avec un pilotage classique, en fonction de la température maximale de la structure poreuse traitée.

Dans ce même cadre, la Demanderesse a apporté d'autres perfectionnements à ce procédé de base mis en oeuvre avec un précurseur aromatique. Lesdits perfectionnements constituent d'autres objets de la présente invention. ils sont présentés ci-après.

Le chauffage mis en oeuvre pour assurer la décomposition du précurseur original de l'invention peut faire intervenir tout type de moyens. Il s'agit généralement d'un chauffage inductif ou d'un chauffage résistif, voire d'un chauffage inductif et/ou résistif. La combinaison de ces deux types de chauffage (i.e. l'intervention conjointe de moyens distincts, adéquats, pour assurer d'une part un chauffage par induction et d'autre part un chauffage par effet Joule) fait partie intégrante du cadre de la présente invention. Toutefois, la Demanderesse préconise plutôt de mettre en oeuvre le procédé de l'invention soit avec un chauffage inductif, soit avec un chauffage résistif. Le chauffage inductif est particulièrement préconisé.

La mise en oeuvre d'un tel chauffage inductif fait avantageusement intervenir un suscepteur. L'homme du métier n'ignore pas a priori l'intérêt d'un tel suscepteur (bien évidemment en un matériau adéquat pour qu'il puisse être chauffé par induction). La structure poreuse à densifier est maintenue au contact dudit suscepteur. Un tel contact structure poreuse à densifier/suscepteur peut se décliner selon plusieurs variantes. La surface de contact peut notamment être plane ou courbe. On peut ainsi "associer" une structure poreuse plane et un suscepteur plan, deux structures poreuses planes de part et d'autre d'un suscepteur plan, une structure poreuse en forme de manchon et un suscepteur cylindrique ....

On rappelle incidemment ici que le procédé de l'invention peut tout à fait inclure un chauffage inductif, sans faire intervenir de suscepteur, dans des conditions électromagnétiques de couplage différentes. Ceci se conçoit aisément pour l'homme du métier.

Pour la mise en oeuvre d'un chauffage résistif, la structure poreuse à densifier peut constituer elle-même le résistor. Toutefois, il est généralement avantageux (au vu notamment de la nature de la pièce à densifier, de son épaisseur...) de faire intervenir un résistor, séparé, isolé électriquement de ladite structure poreuse à densifier. Ainsi trouve-t-on généralement entre un tel résistor et ladite structure poreuse, un isolant électrique, aussi bon conducteur thermique que possible, par exemple en nitrure de bore. On parle alors d'un quasi contact entre ladite structure et ledit résistor. Ledit quasi contact structure poreuse à densifier/résistor peut lui aussi se décliner selon plusieurs variantes ; la surface de quasi contact pouvant elle aussi être notamment plane ou courbe. On peut aussi trouver au quasi contact d'un résistor plan une (deux) structure(s) poreuse(s) plane(s), au quasi contact d'un résistor cylindrique une structure poreuse en forme de manchon.

Ledit contact ou quasi contact, suscepteur/structure poreuse à densifier, résistor/structure poreuse densifier, pouvant poser des problèmes (d'autant plus aigus qu'il est plus intime ; par exemple, dans le cas où la structure poreuse, de forme tubulaire, entoure ledit suscepteur ou ledit résister) :

- lors du refroidissement, en fin de procédé (apparition de fissures dans la structure poreuse densifiée en raison des différences entre le coefficient de dilatation de ladite structure et celui dudit suscepteur ou celui dudit résistor) ; et
- lors de la récupération de la structure poreuse densifiée (lors de sa désolidarisation dudit suscepteur ou dudit résister), à l'issue dudit procédé ;

la Demanderesse a trouvé particulièrement opportun de faire intervenir entre ladite structure poreuse et ledit suscepteur ou ledit résistor un joint de dilatation. Un tel joint, pour développer son action bénéfique présente généralement une épaisseur d'au moins 1 mm. Il présente avantageusement une épaisseur d'au moins 3 mm. Un tel joint peut avantageusement consister en du papier graphite. L'intervention d'un tel joint ne se révèle bien sûr opportune que dans les contextes où intervient un suscepteur et/ou un résistor. Elle est a fortiori opportune, comme mentionné plus haut, lorsque la structure poreuse traitée entoure ledit suscepteur et/ou ledit résistor. Même lorsqu'un tel joint de dilatation intervient, on parle pour des raisons de simplification, de contact ou quasi contact, respectivement entre la structure

poreuse et le suscepteur et entre la structure poreuse et le résistor.

Pour obtenir par ailleurs la densification de la structure poreuse sur toute son épaisseur, qu'un suscepteur ou résistor intervienne ou pas, la Demanderesse propose une innovation. Elle préconise l'intervention d'une autre structure poreuse au contact de la(des) surfaces) libre(s) de ladite structure poreuse à densifier. L'épaisseur de ladite autre structure poreuse est d'au moins 3 mm pour l'obtention de l'effet escompté ; elle est généralement comprise entre 3 et 5 mm. Ladite autre structure poreuse peut consister en un feutre. Ladite autre structure poreuse qui se trouve partiellement densifiée à l'issue du procédé de densification de la structure poreuse, sur toute son épaisseur, intervient au contact de la (des) surfaces) de ladite structure poreuse qui, sans elle, serai(en)t directement au contact de l'hydrocarbure liquide dans lequel ladite structure poreuse à densifier est immergée.

Le procédé de l'invention est évidemment mis en oeuvre à une température adaptée à la nature du précurseur intervenant Ledit précurseur doit se décomposer thermiquement pour générer du carbone. Ledit procédé de l'invention est généralement mis en oeuvre à une température d'au moins 800°C; avantageusement à une température supérieure à 1 000°C. Ladite température du procédé est celle de la zone de dépôt (de densification). Elle est proche de la température du suscepteur ou résistor, dans l'hypothèse où un tel suscepteur ou résistor intervient.

Pour ce qui concerne la pression sous laquelle ledit procédé est mis en oeuvre, elle est généralement comprise entre $0{,}8.10^5$ et $2.10^5$ Pa (entre 0,8 et 2 bars), avantageusement supérieure à $10^5$ Pa (1 bar). On préconise de mettre en oeuvre ledit procédé à une pression supérieure à la pression atmosphérique dans la mesure où, dans de telles conditions, le carbone introduit dans la structure poreuse, se révèle parfaitement graphitisable.

Les structures poreuses densifiées selon l'invention sont généralement, à l'issue du traitement de densification, traitées thermiquement, de préférence sous vide, pour éliminer de leur structure, toute trace de l'hydrocarbure qui est intervenu à titre de précurseur de carbone. Elles peuvent ensuite être destinées à divers types d'applications. S'il est prévu de les traiter thermiquement à des fins de graphitisation, on veillera bien évidemment à mettre en oeuvre le procédé de l'invention dans des conditions telles (notamment de pression) que le carbone de densification déposé soit graphitisable.

Pour ce qui concerne le champ d'application du procédé de l'invention (ci-dessus décrit en termes généraux et ci-après détaillé en référence à la figure annexée et illustré par des exemples), on peut préciser ce qui suit et indiquer d'ores et déjà qu'il est très vaste. Le procédé de densification revendiqué peut notamment s'appliquer à la densification de feutres, tissus, et plus généralement de structures bi- ou tri-dimensionnelles, à base de fibres de carbone ou de fibres céramiques, pouvant être avantageusement utilisés, du fait de leur résistance mécanique élevée et de leur bonne résistance aux chocs et à l'abrasion, pour la réalisation de disques de frein, notamment d'avions. Le procédé de l'invention peut de la même façon être mis en oeuvre pour la rénovation de tels disques de frein. Plus généralement, le procédé de l'invention convient pour la densification, par du carbone, de toute structure poreuse, à base de fibres ou autres ... Il peut notamment convenir pour la densification de mousses à porosité ouverte, d'empilements de sphères (en carbone
ou en céramiques, par exemple ...) Il peut également constituer un traitement complémentaire pour la densification de pièces présentant une très faible porosité, par exemple de l'ordre de 5 % ...

On en vient maintenant au deuxième aspect de la présente invention, à savoir un dispositif utile à la mise en oeuvre du procédé décrit ci-dessus, i.e. un dispositif utile à la densification par caléfaction d'une structure poreuse, caléfaction mise en oeuvre avec un hydrocarbure liquide du type précisé ci-dessus. Un tel dispositif comprend :

- un réacteur au sein duquel la structure poreuse est immergée dans l'hydrocarbure liquide;
- des moyens pour assurer le chauffage (notamment par induction et/ou effet Joule) de l'ensemble structure poreuse/hydrocarbure liquide ;
- des moyens de récupération, à l'état liquide, de l'hydrocarbure vaporisé et/ou entraîné - sous forme d'aérosol - par les gaz de réaction.

Il peut tout à fait s'agir d'un dispositif du type de ceux de l'art antérieur et notamment, dans l'hypothèse d'un chauffage inductif, d'un dispositif du type de celui décrit dans la demande FR-A-2 516 914, lorsque l'hydrocarbure utilisé à titre de précurseur de carbone est à l'état liquide à la température ambiante.

Dans l'hypothèse où ledit hydrocarbure est l'état solide à la température ambiante, il convient d'aménager ledit dispositif de l'art antérieur (qu'il englobe des moyens de chauffage inductif et/ou résistif), tant au niveau de l'alimentation du réacteur en ledit hydrocarbure qu'au niveau des moyens de récupération à l'état liquide dudit hydrocarbure vaporisé et/ou entraîné par les gaz de réaction. Au niveau de l'alimentation, on prévoit avantageusement des moyens de chauffage adéquats. Au niveau de la récupération, on doit également prévoir des moyens de chauffage adéquats en sus de moyens de refroidissement classiquement prévus lorsque ledit hydrocarbure est liquide à la température ambiante. En effet, un tel hydrocarbure - liquide à la température ambiante - lorsqu'il est vaporisé et/ou entraîné par les gaz de réaction va se recondenser au contact de moyens de refroidissement et être ainsi aisément recyclé dans le réacteur (généralement par simple gravité). Par contre, un hydrocarbure - solide à la température ambiante -

se cristalliserait au niveau de tels moyens de refroidissement, encrasserait lesdits moyens et ne pourrait être recyclé aisément dans le réacteur. Avec un tel précurseur lourd, on doit donc prévoir dans le dispositif de l'invention, une combinaison de moyens de refroidissement et de moyens de chauffage pour recycler ledit précurseur lourd vaporisé et/ou entraîné par les gaz de réaction. Au niveau desdits moyens de refroidissement, ledit précurseur lourd entraîné doit être condensé sans cristallisation et au niveau desdits moyens de chauffage ledit précurseur lourd condensé (liquide) doit être maintenu en phase liquide.

On notera incidemment ici que lesdits gaz de réaction consistent principalement en de l'hydrogène et des hydrocarbures légers du type méthane, éthylène, éthane ... On rappelle ici que la mise en oeuvre du procédé de caléfaction avec les précurseurs originaux de l'invention génère une quantité d'hydrocarbure légers bien plus faible que ladite mise en oeuvre avec le cyclohexane.

Pour ce qui concerne les moyens destinés à assurer le chauffage de l'ensemble structure poreuse/hydrocarbure liquide précurseur (de carbone), il peut notamment s'agir de moyens convenant pour un chauffage inductif et/ou résistif.

Les moyens convenant pour un chauffage inductif comprennent une bobine d'induction. Ladite bobine d'induction peut être agencée à l'extérieur du réacteur. Elle est avantageusement disposée dans le réacteur, immergée dans l'hydrocarbure liquide, autour de la structure poreuse. A ladite bobine d'induction est avantageusement associé un suscepteur.

Les moyens convenant pour un chauffage résistif comprennent avantageusement un résistor auquel on associe, comme précisé plus haut, un isolant électrique, aussi bon conducteur thermique que possible.

Ainsi, selon des variantes préférées, le réacteur du dispositif de l'invention renferme un suscepteur et/ou un résistor, généralement un suscepteur ou un résistor. Ledit suscepteur et/ou résister est prévu au (quasi) contact de la structure poreuse à densifier. On trouve généralement ledit suscepteur et/ou ledit résistor sur un support ménagé au sein du réacteur, ledit support pouvant avantageusement être rotatif . Ledit support convient également généralement pour supporter la structure poreuse à densifier et avantageusement l'autre structure poreuse qui peut intervenir au contact de la (des) surfaces) libre(s) de ladite structure poreuse à densifier. Au (quasi) contact de ladite structure poreuse et dudit suscepteur et/ou résistor est avantageusement prévu, comme indiqué plus haut, un joint de dilatation.

On se propose de décrire plus précisément une variante du procédé de l'invention et un dispositif associé, en référence à l'unique figure annexée : la figure 1 sur laquelle on a schématisé un dispositif, susceptible d'être utilisé pour la mise en oeuvre de ladite variante du procédé de l'invention (variante avec chauffage inductif).

A) Ledit dispositif comprend une colonne constituée de trois parties, à savoir un réacteur 1, un dévésiculeur 2 ou piège à aérosols et un condenseur ou échangeur de chaleur 3. La partie réacteur 1 est disposée dans une enceinte de confinement ou boîte à gants 4 balayée intérieurement par un courant de gaz neutre. Celle-ci assure la sécurité du manipulateur en cas de rupture du réacteur et permet d'éviter l'inflammation ou l'explosion des gaz de réaction ainsi que l'inhalation du produit par le manipulateur.

La structure poreuse à densifier 5 est placée sur un support 6 rotatif ou non. Ce support 6 supporte également (variante représentée), en contact avec la structure poreuse 5, un suscepteur 7 (par exemple un mandrin en graphite de façon à pouvoir être chauffé par induction). Le support 6 est monté dans la partie inférieure du réacteur 1 et traverse la tape de fermeture 8 à travers laquelle il peut coulisser.

Le suscepteur 7 et la structure poreuse 5 sont chauffés au moyen d'un dispositif de chauffage par induction constitué de bobines 10 disposées à l'intérieur du réacteur 1 et dans lesquelles circule un courant haute fréquence fourni par un générateur 11. La température de la structure poreuse 5 et du suscepteur 7 sont mesurées par des thermocouples ou thermosondes 12 reliés à un programmateur 13 permettant de réguler la puissance du générateur 11 afin de contrôler la température de dépôt.

En outre, le réacteur 1 comprend un conduit 14 permettant l'introduction du précurseur P (en continu ou en discontinu) à l'intérieur dudit réacteur 1 et un conduit 15 permettant de filtrer en continu, selon une boucle, le contenu dudit réacteur 1 afin d'éliminer les goudrons et suspensions générés dans celui-ci ; ces deux conduits 14 et 15 sont équipés chacun dîme pompe à circulation 16 et 17 (pour des précurseurs solides la température ambiante, tels que le 2-méthylnaphtalène ($C_{11}H_{10}$), la filtration, ainsi que l'injection doivent être équipées d'un système de chauffage une température T, T > T fusion dudit précurseur ( > 40°C pour $C_{11}H_{10}$)). Le réacteur 1 est aussi muni d'un conduit 18 d'azote ou autre gaz neutre servant à chasser l'air contenu dans le réacteur 1 en début de procédé et enfin, d'un orifice muni d'une vanne 19 situé dans la partie inférieure dudit réacteur 1 et permettant la vidange de celui-ci.

Le dévésiculeur 2, situé au-dessus dudit réacteur 1 a pour rôle d'éliminer le brouillard créé au niveau dudit réacteur 1.

Le condenseur ou échangeur de chaleur 3, situé au-dessus du dévésiculeur 2, comprend un serpentin 20 de circulation d'un liquide de refroidissement (généralement de l'eau). L'échangeur de chaleur 3 permet par refroidissement des vapeurs du précurseur P et par condensation de celles-ci de les renvoyer dans le réacteur 1 (cas du précurseur P, liquide à la température ambiante). (Pour des précurseurs solides à la température ambiante, on prévoit une combinaison adéquate moyens de refroidissement/moyens de chauffage).

Les gaz de réaction sont évacués par l'intermédiaire d'une vanne de régulation de pression 21, et menés au travers d'un conduit jusqu'à une installation de traitement des gaz 22 (neutralisation en cas d'emploi de composés halogénés). La vanne de régulation de pression 21 est pilotée par un régulateur 23 relié à un pressostat 24. Le débit des gaz de craquage est mesuré par un débitmètre 25. La ligne 26 permet d'effectuer des analyses de gaz.

L'installation comporte aussi un deuxième pressostat 27 (disposé sur une ligne de sécurité de pression, bas de colonne) afin de connaître la pression dans le réacteur 1, ainsi que deux conduits munis de soupapes de sécurité 28 et 29 afin d'éviter une surpression dans la colonne (tarage à 2 bars). Un explosimètre 30 et un détecteur de HCl 31 sont également placés à proximité de l'installation pour détecter toute fuite de celle-ci.

Les vannes 32, 33, 34 et 35 permettent l'emploi de la pompe 16, soit pour envoyer du précurseur P pendant le cours du procédé, soit pour faire circuler du solvant S, en circuit fermé, à travers les conduits 14 et 36 pour nettoyer l'installation, en fin d'expérimentation.

B) Ledit dispositif est utilisé comme indiqué ci-après.

On dispose la pièce constituée du suscepteur 7 et de la structure poreuse 5 sur le support 6 à l'intérieur du réacteur 1. Le suscepteur 7 peut être avantageusement recouvert d'une fine épaisseur de papier graphite (quelques mm) afin de pouvoir séparer plus facilement, en fin de procédé, ledit suscepteur 7 de ladite structure 5 densifiée. Ledit papier graphite joue aussi le rôle de joint de dilatation et évite l'apparition de fissures sur la pièce lors du refroidissement (en raison des différences de coefficients de dilatation du suscepteur 7 et de la structure 5 densifiée). La structure poreuse 5 peut avantageusement comporter à sa périphérie un feutre de 3 à 5 mm d'épaisseur afin d'obtenir une densification sur toute l'épaisseur de ladite structure.

On place les thermosondes 12 puis l'on effectue un balayage du réacteur 1 et de l'enceinte de confinement 4 à l'aide d'un gaz inerte (tel l'azote), afin de chasser l'oxygène éventuellement présent. On remplit alors le réacteur l avec un précurseur de l'invention, le chlorobenzène, par exemple.

Aprés avoir mis en fonctionnement le circuit réfrigérant 20, l'installation de traitement des gaz 22 et les alimentations électriques, c'est-à-dire la pompe de filtration 17, le générateur 11, le programmateur de température 13 et le régulateur de pression 23, on démarre la montée en température de la pièce (7+5). La pression est fixée à 1,2 bars par l'intermédiaire du régulateur de pression 23.

Dès que le précurseur entre en ébullition, on supprime le balayage de gaz inerte du réacteur 1. Lorsque l'on atteint la température de craquage du précurseur (environ 800°C pour le chlorobenzène) les vapeurs dudit précurseur se décomposent dans la structure poreuse 5, ce qui conduit au dépôt de carbone à l'intérieur des pores du substrat.

Plus précisément le craquage se réalise au niveau des parois les plus chaudes de ladite structure poreuse. Lorsque la structure poreuse 5 est montée sur un suscepteur 7 - comme c'est le cas présentement - le front de densification se propage de l'intérieur de ladite structure poreuse 5 vers la paroi extérieure. (Lorsqu'il n'y a pas de suscepteur, le front de densification progresse depuis l'intérieur de la structure poreuse vers ses parois extérieures placées au contact du précurseur liquide).

La vitesse d'avancée du front de densification peut varier de quelques dixièmes de mm/h au centimètre /h, en fonction de la température maximale de la pièce (7+5) et de sa nature (type de porosité). La température est contrôlée par le programmateur 13 relié au thermocouple 12 placé dans le suscepteur 7 (ou au centre de la structure poreuse, lorsqu'il n'y a pas de suscepteur). La mesure, par le débitmètre 25, des débits de gaz de réaction et la connaissance de leur composition permettent de calculer la vitesse d'avancée du front de densification.

L'ajout (en continu ou non) de précurseur P est effectué afin de conserver une quantité constante de précurseur dans le réacteur 1.

Le mélange gaz de réaction, vapeur non craquée et aérosols produits dans le réacteur 1 est évacué en partie haute de celui-ci. Les aérosols et les vapeurs sont condensés au niveau du dévésiculeur 2 et de l'échangeur 3; les gaz de réaction sont extraits en partie haute de l'installation et neutralisés dans l'installation de traitement des gaz 22. Lorsque le front de densification est à environ 3 mm du bord externe de la structure poreuse, (du bord externe du feutre, lorsqu'un feutre intervient) le débit chute de manière importante, même pour une augmentation de manière significative de la puissance (10 %). Cela est dû à ce que l'épaisseur dans laquelle a lieu le dépôt devient de plus en plus étroite, compte tenu d'une augmentation du gradient thermique (la distance entre le front de température maximale et la zone où l'on est à la température d'ébullition se réduit). On diminue alors progressivement la température jusqu'à la température ambiante.

La pièce obtenue est alors récupérée et subit un traitement thermique de 500°C environ à l'étuve sous vide afin de retirer le précurseur résiduel imprégnant les porosités restantes. Le suscepteur 7 est séparé de l'ensemble et la partie extérieure de la pièce non densifiée (structure ou feutre ajouté, s'il y en avait un) est usinée.

Selon une variante avantageuse, on vidange le précurseur alors que la pièce traitée est encore chaude; ce qui permet de mettre en oeuvre son séchage sans manipulation de celle-ci. Le traitement thermique, destiné à la débarrasser du précurseur résiduel imprégnant ses porosités restantes, peut alors être mis en oeuvre soit au sein du réacteur, soit comme indiqué plus haut dans une étuve.

Les substrats ainsi densifiés selon l'invention sont homogènes, de densité supérieure ou égale à 1,7 et possèdent, après caractérisation par microscopie optique en lumière polarisée, une structure laminaire rugueuse. Cette structure est la plus intéressante car elle permet d'obtenir, par traitement thermique à haute température (2 400°C), une structure proche du graphite. La distance interplans est $d_{002}$ = 3,36 Å et la taille des cristallites est Lc ≈ 1000Å.

On illustre maintenant l'invention par les deux exemples ci-après. ils sont à considérer en référence à la figure 1 annexée et aux commentaires développés ci-dessus en référence à ladite figure 1. L'intérêt de ladite invention est par ailleurs mis en évidence à la considération de l'exemple comparatif donné entre lesdits deux exemples.

Exemple 1

Le précurseur utilisé est le chlorobenzène.

Le réacteur employé a un diamétre intérieur de 200 mm, une hauteur de 300 mm. L'inducteur, qui se trouve dans le réacteur, possède une hauteur de 150 mm et est constitué de 6 spires de diamètres intérieur et extérieur ayant respectivement pour valeurs 175 mm et 195 mm.

Le suscepteur employé est de diamètre 80 mm, hauteur 100 mm. Il est entièrement recouvert à l'aide de préformes fibreuses (fibres de carbone)(densité 0,40 à 0,45) à densifier ; lesdites préformes se présentant sous la forme :

- d'un cylindre creux de diamètres intérieur et extérieur 80 et 160 mm, hauteur 100 mm, recouvrant sa surface latérale (préforme, commercialisée sous la marque Novoltex® , telle que décrite dans FR-A-2 584 107) ,
- de deux disques diamètre 160 mm, épaisseur 40 mm recouvrant en partie haute et basse ses deux surfaces planes (préformes, commercialisées sous la marque Aiguitex® , telles que décrites dans FR-A-2 584 106).

La masse totale de préformes fibreuses représente 1 240 g.

La pression est fixée à 1,2 bar. Le réacteur est rempli de chlorobenzène. La montée en température s'effectue à une vitesse de 500°C/h jusqu'à 1 100°C. Le débit de gaz craqués est alors d'environ 8,5 l/min et l'on ajuste la puissance au cours du temps de manière à conserver ce débit peu prés constant. Après environ 9 h de densification, on procède à la descente en température à une vitesse de 800°C/h.

La masse de carbone déposée représente 3 810 g, pour une consommation de chlorobenzène de 6 l. Le rendement en carbone calculé est de 88 % (il passe à 96 % si l'on ne considère pas comme consommées, environ 3 moles de chlorobenzène, entraînées par les gaz de réaction et qu'il est possible de récupérer, par condensation, à -5°C). La vitesse de densification a été de 4,1 mm/h et la consommation électrique d'environ 60 kWh/kg de carbone déposé.

Après usinage des 3 mm extérieurs, la densité des différentes pièces est de 1,72. Le carbone obtenu est de structure du type laminaire rugueux précité.

Exemple comparatif

Le précurseur utilisé est le cyclohexane.

Il est utilisé dans les conditions de l'exemple 1. Les résultats obtenus permettent de calculer :

- avec une consommation de 61 litres de cyclohexane, un rendement en carbone de 9 %;
- une vitesse de densification de 1,9 mm/h ;
- une consommation électrique de 120 kWh/kg (de carbone déposé).

Exemple 2

Le précurseur utilisé est le toluène.

Le réacteur et l'inducteur employés sont les mêmes que pour l'exemple 1 avec le chlorobenzène. Le suscepteur possède un diamètre de 80 mm et une hauteur de 156 mm et est revêtu de papier graphite (joint de dilatation) sur une épaisseur de 2 mm. Il est recouvert :

- sur sa surface latérale par la pièce à densifier qui est un manchon fibreux en carbone (densité 0,4) de hauteur 140 rnm, Ø extérieur 165 mm.
- sur ses surfaces planes haute et basse par deux disques de feutre carbone (densité 0,1) de diamètre 165 mm et d'épaisseur 6 mm.

La pression est fixée à 1 bar. Le réacteur est rempli de toluène (11 l). La montée en température s'effectue à une vitesse de 500°C/h jusqu'à 1 200°C. Le débit de gaz de réaction est d'environ 3 l/min et l'on ajuste la puissance

au cours du temps afin de garder une vitesse d'avancée du front de densification à peu prés constante. Après 6 heures de densification, on procède à la descente en température à une vitesse de 800°C/h.

La masse de carbone totale déposée est de 3 510 g pour une consommation de 7,5 l de toluène. Le rendement en carbone calculé est de 60 %.

La vitesse de densification a été de 6 mm/h et la consommation énergétique de 60 kWh/kg de carbone déposé.

Après usinage des 3 mm extérieurs du manchon densifié, la densité dudit manchon est de 1,75 . Le carbone obtenu est de structure du type laminaire rugueux précité.

L'emploi du toluène au lieu du cyclohexane permet, de même que pour le chlorobenzène, des augmentations extrêmement importantes de la vitesse de densification et du rendement matière ainsi qu'une diminution de la consommation énergétique.

## Revendications

1. Procédé de densification d'une structure poreuse, comprenant le maintien de ladite structure poreuse immergée dans un hydrocarbure liquide et le chauffage de l'ensemble structure poreuse/hydrocarbure liquide de sorte que le carbone obtenu par décomposition dudit hydrocarbure se dépose en partie dans les pores de ladite structure poreuse, **caractérisé en ce que** a) ledit hydrocarbure répond à l'une ou l'autre des formules (I) et (II) ci-après:

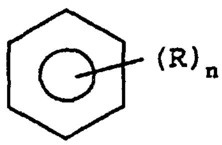 (I) 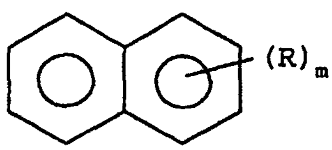 (II)

dans lesquelles :

n = 1,2, 3 ou 4,
m = 0,1 ,2,3 ou 4,
R représente, indépendamment, un halogène, de préférence le chlore, ou un groupement alkyle choisi parmi les groupes méthyle, éthyle, n-propyle ou i-propyle,

ou consiste en un mélange d'au moins deux hydrocarbures répondant à l'une et/ou l'autre desdites formules (I) et (II);

et **en ce que** b) il est piloté en fonction du débit et de la composition des gaz de la réaction.

2. Procédé de densification selon la revendication 1, **caractérisé en ce que** ledit hydrocarbure consiste en le toluène ou le chlorobenzène.

3. Procédé de densification selon l'une des revendications 1 ou 2, **caractérisé en ce que** ledit chauffage de l'ensemble structure poreuse/hydrocarbure liquide est un chauffage inductif, avantageusement mis en oeuvre avec un suscepteur (7) ou un chauffage résistif, avantageusement mis en oeuvre avec un résistor; ladite structure poreuse à densifier (5) étant maintenue au contact dudit suscepteur (7) ou au quasi contact dudit résistor, intervenant avantageusement.

4. Procédé de densification selon la revendication 3, **caractérisé en ce que** ledit chauffage est un chauffage inductif mis en oeuvre avec un suscepteur (7) ou un chauffage résistif mis en oeuvre avec un résistor ; un joint de dilatation étant disposé entre ladite structure poreuse à densifier (5) et ledit suscepteur (7) ou ledit résistor.

5. Procédé de densification selon l'une quelconque des revendications 1 à 4, **caractérisé en ce qu'**une autre structure poreuse, d'une épaisseur au moins égale à 3 mm, telle un feutre, est maintenue au contact de la (des) surface (s) libre(s) de ladite structure poreuse à densifier (5), de sorte que ladite structure (5) puisse être densifiée sur toute son épaisseur.

6. Procédé de densification selon l'une quelconque des revendications précédentes, **caractérisé en ce qu'**il est mis en oeuvre dans un dispositif comprenant :

- un réacteur (1) au sein duquel la structure poreuse (5) est immergée dans l'hydrocarbure liquide;
- des moyens pour assurer le chauffage de l'ensemble structure poreuse (5)/hydrocarbure liquide ;
- des moyens de récupération, à l'état liquide, de l'hydrocarbure vaporisé et/ou entraîné par les gaz de réaction.

**7.** Procédé de densification selon la revendication 6, **caractérisé en ce que** lesdits moyens de récupération de l'hydrocarbure vaporisé et/ou entraîné comprennent, selon la nature dudit hydrocarbure, soit des moyens de refroidissement, soit une combinaison moyens de refroidissement/moyens de chauffage, lesdits moyens de chauffage étant alors disposés au dessus desdits moyens de refroidissement.

**8.** Procédé de densification selon l'une des revendications 6 ou 7, **caractérisé en ce que** lesdits moyens pour assurer le chauffage comprennent une bobine d'induction; avantageusement placée dans l'hydrocarbure liquide et entourant la structure poreuse (5).

**9.** Procédé de densification selon l'une quelconque des revendications 6 à 8, **caractérisé en ce qu'**il comprend au contact de ladite structure poreuse (5) un suscepteur (7) ou au quasi contact de ladite structure poreuse(5) un résistor.

## Patentansprüche

**1.** Verfahren zum Verdichten einer porösen Struktur, aufweisend das eingetaucht Halten der besagten porösen Struktur in einem flüssigen Kohlenwasserstoff und das Erhitzen der Anordnung der porösen Struktur / des flüssigen Kohlenwasserstoffs derart, daß der durch Zersetzung des Kohlenwasserstoffs erhaltene Kohlenstoff sich teilweise in den Poren der besagten porösen Struktur absetzt, **dadurch gekennzeichnet, daß** a) der besagte Kohlenwasserstoff einer der beiden nachfolgenden Formeln (I) und (II) entspricht:

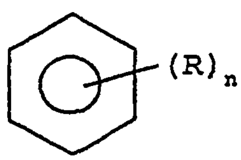
(I)

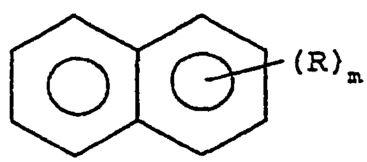
(II)

in welchen:

n= 1, 2, 3 oder 4
m= 0, 1, 2, 3 oder 4
R unabhängig ein Halogen, vorzugsweise Chlor, oder eine Alkylgruppe, gewählt aus der Methyl-, Ethyl-, n-Propyl oder i-Propylgruppe repräsentiert;

oder aus einer Mischung von mindestens zwei Kohlenwasserstoffen entsprechend der einen und / oder der anderen der beiden besagten Formeln (I) und (II) besteht;
und daß b) es gesteuert wird in Abhängigkeit der Menge und der Zusammensetzung der Reaktionsgase.

**2.** Verfahren zum Verdichten nach Anspruch 1, **dadurch gekennzeichnet, daß** der Kohlenwasserstoff aus Toluol oder Chlorbenzol besteht.

**3.** Verfahren zum Verdichten nach einem der Ansprüche 1 oder 2, **dadurch gekennzeichnet, daß** das Erhitzen der Anordnung der porösen Struktur / des flüssigen Kohlenwasserstoffs ein Erhitzen durch Induktion ist, vorzugsweise durchgeführt mit einem Suszeptor (7), oder ein Widerstandserhitzen, vorzugsweise durchgeführt mit einem Widerstand, ist; wobei die zu verdichtende poröse Struktur (5) in Kontakt mit dem vorzugsweise vorhandenen Suszeptor (7) gehalten oder in Quasi-Kontakt mit dem vorzugsweise vorhandenen Widerstand gehalten wird.

**4.** Verfahren zum Verdichten nach Anspruch 3, **dadurch gekennzeichnet, daß** das Erhitzen ein Erhitzen durch Induktion ist, das mit einem Suszeptor (7) durchgeführt wird, oder ein Widerstandserhitzen, das mit einen Widerstand durchgeführt wird; wobei eine Dehnungsverbindung zwischen der zu verdichtenden porösen Struktur (5) und dem Suszeptor (7) oder dem Widerstand vorgesehen ist.

**5.** Verfahren zum Verdichten nach einem der Ansprüche 1 bis 4, **dadurch gekennzeichnet, daß** eine andere poröse Struktur mit einer Dicke von mindestens 3 mm, wie ein Filz, in Kontakt mit der freien Oberfläche (den freien Oberflächen) der porösen zu verdichtenden Struktur (5) gehalten wird, so daß die Struktur (5) über ihre gesamte Dicke verdichtet werden kann.

**6.** Verfahren zum Verdichten nach einem der vorangegangenen Ansprüche, **dadurch gekennzeichnet, daß** es in einer Vorrichtung durchgeführt wird, aufweisend:

- einen Reaktor (1), in welchem die poröse Struktur (5) in den flüssigen Kohlenwasserstoff eingetaucht wird;
- Mittel, um die Erhitzung der Anordnung der porösen Struktur (5) / der Kohlenstoffflüssigkeit sicherzustellen;
- Mittel zur Rückgewinnung des verdampften und/oder durch die Reaktionsgase verschleppten Kohlenwasserstoffs in der flüssigen Phase.

**7.** Verfahren zum Verdichten nach Anspruch 6, **dadurch gekennzeichnet, daß** die besagten Mittel zur Rückgewinnung des verdampften und/oder verschleppten Kohlenwasserstoffs entsprechend der Eigenschaften des Kohlenwasserstoffs entweder Mittel zum Abkühlen oder eine Kombination von Mitteln zum Abkühlen und Mitteln zum Erhitzen aufweisen, wobei die besagten Mittel zum Erhitzen über den besagten Mitteln zum Abkühlen vorgesehen sind.

**8.** Verfahren zum Verdichten nach einem der Ansprüche 6 oder 7, **dadurch gekennzeichnet, daß** die Mittel zum Sicherstellen der Erhitzung eine Induktionsspule (13) aufweisen, die vorzugsweise in dem flüssigen Kohlenwasserstoff und um die poröse Struktur (5) herum plaziert ist.

**9.** Verfahren zum Verdichten nach einer der Ansprüche 6 bis 8, **dadurch gekennzeichnet, daß** es einen Suszeptor (7) im Kontakt mit der porösen Struktur (5) oder einen Widerstand im Quasi-Kontakt mit der besagten porösen Struktur (5) aufweist.

## Claims

**1.** A densification method for densifying a porous structure, the method comprising maintaining said porous structure immersed in a liquid hydrocarbon and heating the porous structure/liquid hydrocarbon assembly so that a portion of the carbon obtained by decomposition of said hydrocarbon is deposited in the pores of said porous structure, the method being **characterized in that** a) said hydrocarbon has either formula (I) or formula (II) below:

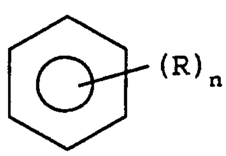
(I)

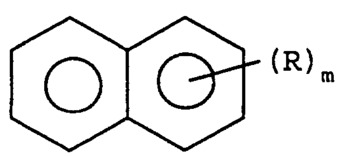
(II)

in which:

n = 1, 2, 3 or 4;
m = 0, 1, 2, 3 or 4;
R independently represents a halogen, preferably chlorine, or an alkyl group selected from methyl, ethyl, n-propyl or i-propyl groups;

or consists of a mixture of at least two hydrocarbons having one and/or the other of said formulae (I) and (II); and
**in that** b) it is controlled as a function of the flow rate and the composition of the gases from the reaction.

**2.** The densification method according to claim 1, **characterized in that** said hydrocarbon consists of toluene or chlorobenzene.

3. The densification method according to claim 1 or claim 2, **characterized in that** said heating of the porous structure/liquid hydrocarbon assembly is inductive heating, advantageously implemented by means of an induction core (7), or resistive heating, advantageously implemented by means of a resistor; said porous structure to be densified (5) being maintained in contact with said induction core (7) or in quasi contact with said resistor, which susceptor (8) or resistor being advantageously employed.

4. The densification method according to claim 3, **characterized in that** said heating is inductive heating implemented with an induction core (7) or resistive heating implemented with a resistor; an expansion joint being disposed between said porous structure to be densified (5) and said induction core (7) or said resistor.

5. The densification method according to any one of claims 1 to 4, **characterized in that** a further porous structure, with a thickness of at least 3 mm, such as a felt, is maintained in contact with the free surface(s) of said porous structure to be densified (5), such that said structure (5) can be densified over its entire thickness.

6. The densification method according to any preceding claims, **characterized in that** it is carried out in an apparatus comprising:

- a reactor (1) in which the porous structure (5) is immersed in the hydrocarbon liquid;
- means for heating the porous structure (5)/hydrocarbon liquid assembly;
- means for recovering, in the liquid state, vaporized hydrocarbon and/or hydrocarbon stripped by the reaction gases.

7. The densification method according to claim 6, **characterized in that** said means for recovering vaporized and/or entrained hydrocarbon comprise, depending on the nature of said hydrocarbon, either cooling means or a combination of cooling and heating means, said heating means then being disposed above said cooling means.

8. The densification method according to claim 6 or claim 7, **characterized in that** said means for ensuring heating comprise an induction core, advantageously placed in the liquid hydrocarbon and surrounding the porous structure (5).

9. The densification method according to any one of claims 6 to 8, **characterized in that** it comprises a induction core (7) in contact with said porous structure (5), or a resistor in quasi contact with said porous structure (5).

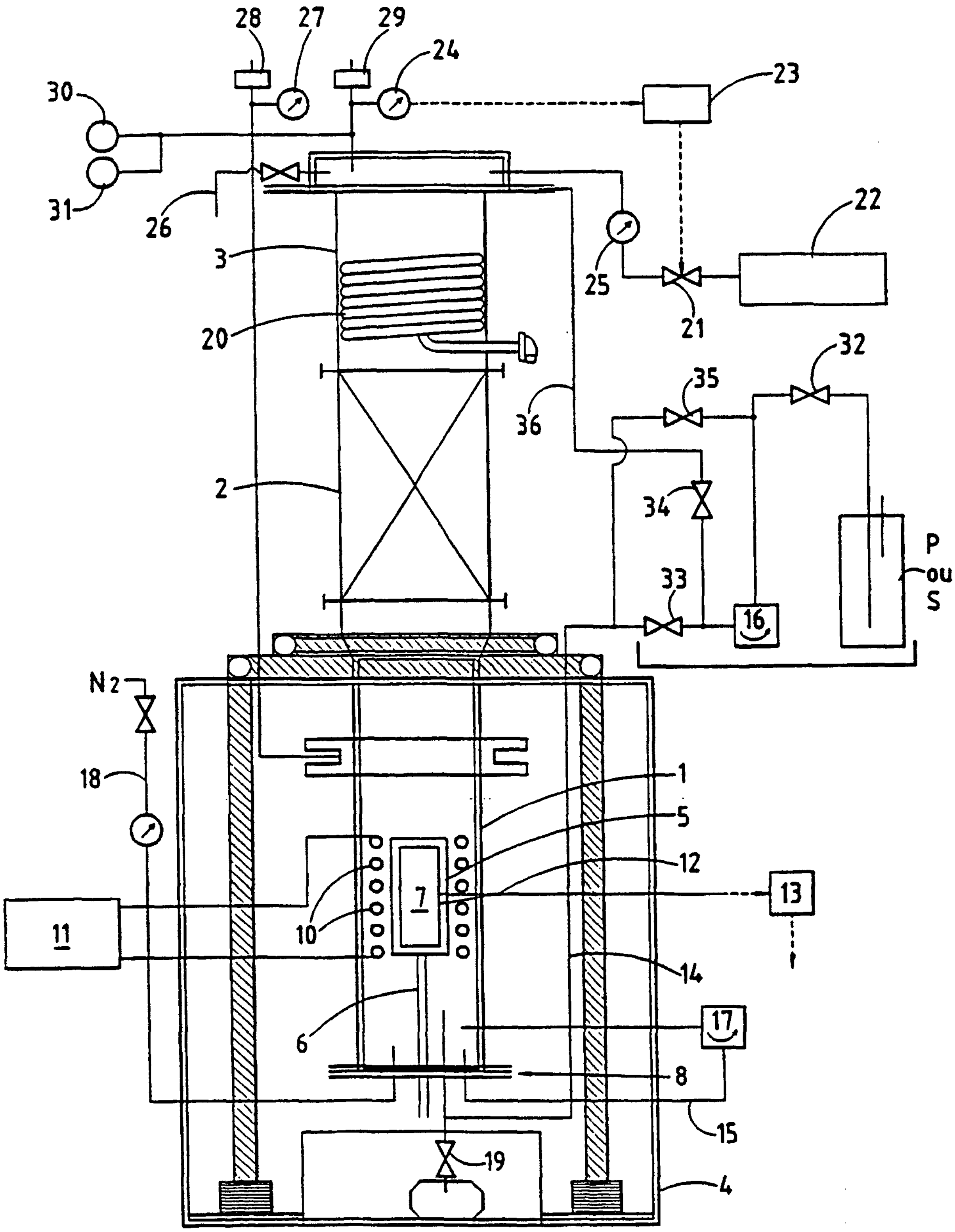
28
27
29
24
23
30
31
26
22
3
25
21
20
32
35
36
2
34
P
ou
S
33
16
N2
1
18
5
12
13
7
10
11
14
6
17
8
15
19
4

FIG.1